# EUROPÄISCHE PATENTSCHRIFT

(11) **EP 3 030 936 B1**
(45) Veröffentlichungstag und Bekanntmachung des Hinweises auf die Patenterteilung: **27.02.2019**
(21) Anmeldenummer: 14739073.6
(22) Anmeldetag: 25.06.2014
(51) Int. Cl.: G03F 7/20, G21K 1/06, G02B 5/08

(54) **SPIEGEL FÜR EINE MIKROLITHOGRAPHISCHE PROJEKTIONSBELICHTUNGSANLAGE**
MIRROR FOR A MICROLITHOGRAPHIC PROJECTION EXPOSURE APPARATUS
MIROIR POUR APPAREIL D'EXPOSITION PAR PROJECTION MICROLITHOGRAPHIQUE

(30) Priorität: 07.08.2013 DE 102013215541
(43) Veröffentlichungstag der Anmeldung: 15.06.2016
(73) Patentinhaber: Carl Zeiss SMT GmbH, 73447 Oberkochen (DE)
(72) Erfinder: HERMANN, Martin, 89518 Heidenheim (DE)
(74) Vertreter: Frank, Hartmut
(86) Internationale Anmeldenummer: PCT/EP2014/063349
(87) Internationale Veröffentlichungsnummer: WO 2015/018560

(56) Entgegenhaltungen:
- EP-A1- 1 365 263
- WO-A1-2012/126954
- CN-B- 1 900 745
- DE-A1-102004 002 757
- US-A1- 2005 199 830
- IONASCUT-NEDELCESCU A ET AL: "Radiation Hardness of Gallium Nitride", IEEE TRANSACTIONS ON NUCLEAR SCIENCE, IEEE SERVICE CENTER, NEW YORK, NY, US, Bd. 49, Nr. 6, 1. Dezember 2002 (2002-12-01), XP011077908, ISSN: 0018-9499 in der Anmeldung erwähnt
- SELLIN P J ET AL: "New materials for radiation hard semiconductor dectectors", NUCLEAR INSTRUMENTS & METHODS IN PHYSICS RESEARCH. SECTION A: ACCELERATORS, SPECTROMETERS, DETECTORS, AND ASSOCIATED EQUIPMENT, ELSEVIER BV * NORTH-HOLLAND, NL, Bd. 557, Nr. 2, 15. Februar 2006 (2006-02-15), Seiten 479-489, XP027924454, ISSN: 0168-9002 [gefunden am 2006-02-15] in der Anmeldung erwähnt
- LANKE U ET AL: "Effect of ion-energy on the properties of amorphous GaN films produced by ion-assisted deposition", MODERN PHYSICS LETTERS B, SINGAPORE, SG, Bd. 15, Nr. 28-29, 20. Dezember 2001 (2001-12-20), Seiten 1355-1360, XP009117015, DOI: 10.1142/S0217984901003275
- BITTAR A ET AL: "Ion-assisted deposition of amorphous GaN: Raman and optical properties", APPLIED PHYSICS LETTERS, AMERICAN INSTITUTE OF PHYSICS, US, Bd. 78, Nr. 5, 29. Januar 2001 (2001-01-29), Seiten 619-621, XP012028509, ISSN: 0003-6951, DOI: 10.1063/1.1345800

## Beschreibung

### HINTERGRUND DER ERFINDUNG

### Gebiet der Erfindung

Die Erfindung betrifft einen Spiegel für eine mikrolithographische Projektionsbelichtungsanlage.

### Stand der Technik

Mikrolithographie wird zur Herstellung mikrostrukturierter Bauelemente, wie beispielsweise integrierter Schaltkreise oder LCD's, angewendet. Der Mikrolithographieprozess wird in einer sogenannten Projektionsbelichtungsanlage durchgeführt, welche eine Beleuchtungseinrichtung und ein Projektionsobjektiv aufweist. Das Bild einer mittels der Beleuchtungseinrichtung beleuchteten Maske (= Retikel) wird hierbei mittels des Projektionsobjektivs auf ein mit einer lichtempfindlichen Schicht (Photoresist) beschichtetes und in der Bildebene des Projektionsobjektivs angeordnetes Substrat (z.B. ein Siliziumwafer) projiziert, um die Maskenstruktur auf die lichtempfindliche Beschichtung des Substrats zu übertragen.

In für den EUV-Bereich ausgelegten Projektionsobjektiven, d.h. bei Wellenlängen von z.B. etwa 13 nm oder etwa 7 nm, werden mangels Verfügbarkeit geeigneter lichtdurchlässiger refraktiver Materialien Spiegel als optische Komponenten für den Abbildungsprozess verwendet. Solche EUV-Spiegel weisen ein Spiegelsubstrat und einen aus einer Vielzahl von Schichtpaketen aufgebauten Reflexionsschichtstapel zur Reflexion der auf die optische Wirkfläche auftreffenden elektromagnetischen Strahlung auf. Als Spiegelsubstratmaterial sind - etwa in der Beleuchtungseinrichtung - metallische Materialien wie z.B. Kupfer oder Aluminium, oder auch - etwa im Projektionsobjektiv - amorphe Spiegelsubstratmaterialien wie Titandioxid (TiO₂)-dotiertes Quarzglas (wie etwa unter den Markenbezeichnungen ULE oder Zerodur vertrieben) bekannt.

Da sich fertigungstechnisch bei der Herstellung des Spiegels eine hinreichende Politur diverser (insbesondere metallischer) Spiegelsubstratmaterialien nicht ohne weiteres erreichen lässt, werden in der Regel zusätzliche Polierschichten z.B. aus amorphem Silizium (= a-Si) verwendet, welche sich mit höherer Präzision bearbeiten lassen. Dabei tritt jedoch in der Praxis u.a. das Problem auf, dass solche Polierschichten sowie ggf. auch das Spiegelsubstratmaterial selbst aufgrund der Strahlungsbelastung durch das auftreffende EUV-Licht strukturelle Veränderungen z.B. aufgrund von Kompaktierungseffekten zeigen, die sich wiederum auf die Geometrie des aufgebrachten Reflexionsschichtstapels und damit auf die Reflexionseigenschaften des Spiegels auswirken.

Ein weiteres, im Betrieb der Projektionsbelichtungsanlage aufgrund der Strahlungsbelastung durch EUV-Licht auftretendes Problem resultiert aus strahlungsbedingten Alterungseffekten des Spiegelsubstratmaterials selbst, insbesondere wenn z.B. im Projektionsobjektiv die o.g. amorphen Spiegelsubstratmaterialien eingesetzt werden. Zum Schutz solcher Spiegelsubstratmaterialien sowie ggf. auch der zuvor genannten Polierschichten hat sich u.a. auch die Verwendung von Schutzschichten (kurz: SPL= "Substrate Protection Layer" = Substrat-Schutzschicht) als sinnvoll erwiesen, welche aus einem das EUV-Licht vergleichsweise stark absorbierenden Material hergestellt sein können.

Zum Stand der Technik wird lediglich beispielhaft auf die Publikationen A. lonascut-Nedelcescu et al.: "Radiation Hardness of Gallium Nitride", IEEE Transactions on Nuclear Science Vol. 49 (2002), S. 2733-2738; Xueping Xu et al.: "Fabrication of GaN wafers for electronic and optoelectronic devices", Optical Materials 23 (2003), S. 1-5 und P.J. Sellin et al.: "New materials for radiation hard semiconductor detectors", CERN-OPEN-2005-005, S. 1-24 verwiesen. WO2012/126954 offenbart einen Spiegel einer mikrolithographischen Projektionsbelichtungsanlage, wobei zwischen zwei Reflexionsschichtstapeln Aluminiumnitrid (AlN) enthaltende Elektrodenschichten angeordnet sind.

### ZUSAMMENFASSUNG DER ERFINDUNG

Es ist eine Aufgabe der vorliegenden Erfindung, einen Spiegel für eine mikrolithographische Projektionsbelichtungsanlage, bereitzustellen, bei dem unerwünschte strahlungsinduzierte strukturelle Veränderungen des Schichtaufbaus und damit unerwünschte Beeinträchtigungen der Reflexionseigenschaften besonders wirksam vermieden werden.

Diese Aufgabe wird gemäß den Merkmalen des unabhängigen Patentanspruchs 1 gelöst.

Ein erfindungsgemäßer Spiegel für eine mikrolithographische Projektionsbelichtungsanlage, weist eine optische Wirkfläche, ein Spiegelsubstrat und einen Reflexionsschichtstapel zur Reflexion von auf die optische Wirkfläche auftreffender elektromagnetischer Strahlung auf, wobei zwischen dem Spiegelsubstrat und dem Reflexionsschichtstapel eine Schicht aus einem Gruppe-III-Nitrid angeordnet ist, wobei das Gruppe-III-Nitrid aus der Gruppe ausgewählt ist, die Galliumnitrid (GaN), Aluminiumnitrid (AlN) und Aluminium-Gallium-Nitrid (AlGaN) enthält, wobei die Schicht eine Dicke im Bereich von 0.1 µm bis 100 µm aufweist.

Der Erfindung liegt insbesondere das Konzept zugrunde, im Schichtaufbau eines Spiegels einer für den Betrieb im EUV ausgelegten mikrolithographischen Projektionsbelichtungsanlage zwischen dem Spiegelsubstrat und dem Reflexionsschichtstapel eine amorphe Schicht aus einem Gruppe-III-Nitrid (d.h. ein Nitrid, welches eines oder mehrere Elemente der dritten Hauptgruppe im Periodensystem aufweist), wie z.B. Galliumnitrid (GaN) oder Aluminiumnitrid (AlN) einzusetzen.

Dabei geht die Erfindung u.a. von der Überlegung aus, dass ein Material wie Galliumnitrid aufgrund der vergleichsweise hohen Bindungsenergie bzw. der (beispielsweise relativ zu amorphem Silizium) hohen energetischen Barriere gegenüber der Verschiebung eines Atoms aus seiner Gitterposition ("Atomic Displacement Energy") relativ unempfindlich gegenüber elektromagnetischer Bestrahlung ist und somit eine entsprechend hohe Strahlungsresistenz aufweist, was wiederum beim erfindungsgemäßen Einsatz als Polierschicht und/oder Schutzschicht in einem EUV-Spiegel vorteilhaft ausgenutzt werden kann. So beträgt die Bindungsenergie für Silizium etwa 3.6eV, für amorphes Silizium (a-Si) etwa 4eV bis 4.8eV, für Galliumnitrid (GaN) etwa 8.9eV und für Aluminiumnitrid (AlN) etwa 11.5eV.

Zugleich macht sich die Erfindung den Umstand zunutze, dass das ebenfalls wünschenswerte Kriterium eines möglichst geringen Unterschiedes in Temperaturausdehnungskoeffizienten zum Reflexionsschichtstapel einerseits und zum Spiegelsubstratmaterial andererseits für ein Material wie Galliumnitrid etwa im Vergleich zu amorphem Silizium noch besser erfüllt ist, wie im Weiteren noch detaillierter ausgeführt wird.

Des Weiteren geht die Erfindung auch von der z.B. im Falle von kristallinen Galliumnitrid-Schichten bestehenden Erkenntnis aus, dass sich z.B. bei Galliumnitrid durch Materialabtragung unter Einsatz unterschiedlicher möglicher Poliermittel hinreichend geringe Rauigkeiten erzielen lassen, die die Funktionalität der vorstehend beschriebenen Polierschicht gewährleisten. Im Falle des Vorliegens von Mischphasen aus kristallinem und amorphem Material ist jedoch i.d.R. die Polierbarkeit verschlechtert.

Dabei nimmt die Erfindung bewusst fertigungstechnische Herausforderungen in Kauf, welche sich daraus ergeben, dass zum einen die Aufbringung der erfindungsgemäßen (z.B. Galliumnitrid-)Schicht zur Vermeidung einer Schädigung insbesondere des Spiegelsubstratmaterials (z.B. ULE oder Zerodur) bei vergleichsweise niedrigen Temperaturen unterhalb von ca. 100°C-200°C zu erfolgen hat und zum anderen auch die Bildung von Kristalliten in dem Schichtmaterial (zu der etwa in Galliumnitrid auch bei den vorstehend genannten relativ niedrigen Temperaturen eine gewisse Neigung besteht) und eine damit einhergehende Änderung der Poliereigenschaften bzw. -raten und Beeinträchtigung der Eignung als Polierschicht zu vermeiden ist.

Erfindungsgemäß wurde insbesondere herausgefunden, dass die genannten fertigungstechnischen Herausforderungen durch Einsatz geeigneter Verfahren (insbesondere Stickstoffionen-gestütztem (Gallium-)Aufdampfen unter Bereitstellung eines Überangebots an Stickstoff während der Beschichtung sowie vergleichsweise hoher Stickstoffionenenergie zur Erzielung eines amorphen Materials) zu meistern sind.

Aufgrund der vorstehend beschriebenen vorteilhaften Eigenschaften der erfindungsgemäßen Galliumnitrid-Schicht kann diese Schicht insbesondere eine Doppelfunktion insofern wahrnehmen, als sie zum einen als Polierschicht und zum anderen als Schutzschicht bzw. Absorberschicht zum Schutz eines im Schichtaufbau darunter befindlichen Spiegelsubstrats z.B. aus ULE oder Zerodur oder einem metallischen Spiegelsubstratmaterial dient. In diesem Falle kann z.B. auf eine weitere Polierschicht etwa aus amorphem Silizium verzichtet werden.

Die Erfindung ist jedoch auf die Nutzung der vorstehend beschriebenen Doppelfunktion nicht beschränkt. So kann in weiteren Ausführungsformen auch die erfindungsgemäße (z.B. Galliumnitrid-)Schicht zusätzlich zu einer vorhandenen Polierschicht (etwa aus amorphem Silizium) auf dieser Polierschicht aufgebracht werden, um unter Ausnutzung der Wirkung als Absorberschicht einen Schutz sowohl der Polierschicht als auch des darunter befindlichen Spiegelsubstratmaterials vor strahlungsinduzierten Effekten und strukturellen Änderungen infolge des EUV-Lichtes zu gewährleisten.

Gemäß einer Ausführungsform ist das Gruppe-III-Nitrid amorph.

Bei dem Gruppe-III-Nitrid kann es sich insbesondere um eine binäre oder eine ternäre Verbindung handeln.

Gemäß einer Ausführungsform weist die Schicht eine Dicke im Bereich von 0.5 µm bis 50 µm, auf.

Gemäß einer Ausführungsform ist die Schicht unmittelbar auf dem Spiegelsubstrat oder auf einer auf dem Spiegelsubstrat befindlichen (z.B. stickstoffhaltigen) Haftvermittlerschicht angeordnet.

Gemäß einer Ausführungsform ist die Schicht auf einer Polierschicht angeordnet. Gemäß einer Ausführungsform ist das Spiegelsubstrat aus einem metallischen Material (z.B. Kupfer (Cu) oder Aluminium (Al)) hergestellt.

Gemäß einer Ausführungsform ist das Spiegelsubstrat aus einem amorphen Material, insbesondere Titandioxid (TiO₂)-dotiertem Quarzglas, hergestellt.

Der Spiegel kann insbesondere für eine Arbeitswellenlänge von weniger als 30 nm, insbesondere weniger als 15 nm, ausgelegt sein. Die Erfindung ist jedoch auch hierauf nicht grundsätzlich beschränkt und in weiteren Ausführungsformen auch in einem für Arbeitswellenlängen im VUV-Bereich (z.B. kleiner als 200nm) ausgelegten Spiegel realisierbar.

Die Erfindung betrifft weiter ein optisches System einer mikrolithographischen Projektionsbelichtungsanlage, insbesondere eine Beleuchtungseinrichtung oder Projektionsobjektiv, wobei das optische System wenigstens einen Spiegel mit den vorstehend beschriebenen Merkmalen aufweist.

Gemäß einem weiteren Aspekt betrifft die Erfindung ein Verfahren zum Herstellen eines Spiegels für eine mikrolithographische Projektionsbelichtungsanlage, wobei auf einem Spiegelsubstrat ein Schichtsystem aufgebracht wird, welches einen Reflexionsschichtstapel zur Reflexion von auf die optische Wirkfläche auftreffender elektromagnetischer Strahlung aufweist, wobei vor dem Aufbringen des Reflexionsschichtstapels eine Schicht aus einem Gruppe-III-Nitrid aufgebracht wird, wobei das Gruppe-III-Nitrid aus der Gruppe ausgewählt ist, die Galliumnitrid (GaN), Aluminiumnitrid (AlN) und Aluminium-Gallium-Nitrid (AlGaN) enthält, wobei die Schicht eine Dicke im Bereich von 0.1 µm bis 100 µm aufweist.

Die Schicht aus dem Gruppe-III-Nitrid kann durch Stickstoffionen-gestütztes Aufdampfen oder mit einem anderen geeigneten Verfahren wie z.B. Sputtern, nachträgliche Ionenimplantation etc. aufgebracht werden.

Gemäß einer Ausführungsform wird die Schicht vor Aufbringen des Reflexionsschichtstapels poliert.

Gemäß einer Ausführungsform wird in die Schicht ein Oberflächenprofil eingearbeitet, welches eine in dem Schichtsystem des Spiegels vorhandene, durch mechanische Verspannung induzierte Deformation wenigstens teilweise kompensiert. Weitere Ausgestaltungen der Erfindung sind der Beschreibung sowie den Unteransprüchen zu entnehmen.

Die Erfindung wird nachstehend anhand von in den beigefügten Abbildungen dargestellten Ausführungsbeispielen näher erläutert.

### KURZE BESCHREIBUNG DER ZEICHNUNGEN

Es zeigen:
- Figur 1: eine schematische Darstellung zur Erläuterung des Aufbaus eines Spiegels mit einem metallischen Spiegelsubstratmaterial gemäß einer ersten Ausführungsform der Erfindung;
- Figur 2: eine schematische Darstellung zur Erläuterung des Aufbaus eines Spiegels mit einem metallischen Spiegelsubstratmaterial gemäß einer weiteren Ausführungsform der Erfindung;
- Figur 3-4: schematische Darstellungen zur Erläuterung des Aufbaus eines Spiegels mit einem amorphen Spiegelsubstratmaterial gemäß weiterer Ausführungsformen der Erfindung; und
- Figur 5: eine schematische Darstellung eines beispielhaften Aufbaus einer mikrolithographischen Projektionsbelichtungsanlage.

### DETAILLIERTE BESCHREIBUNG BEVORZUGTER AUSFÜHRUNGSFORMEN

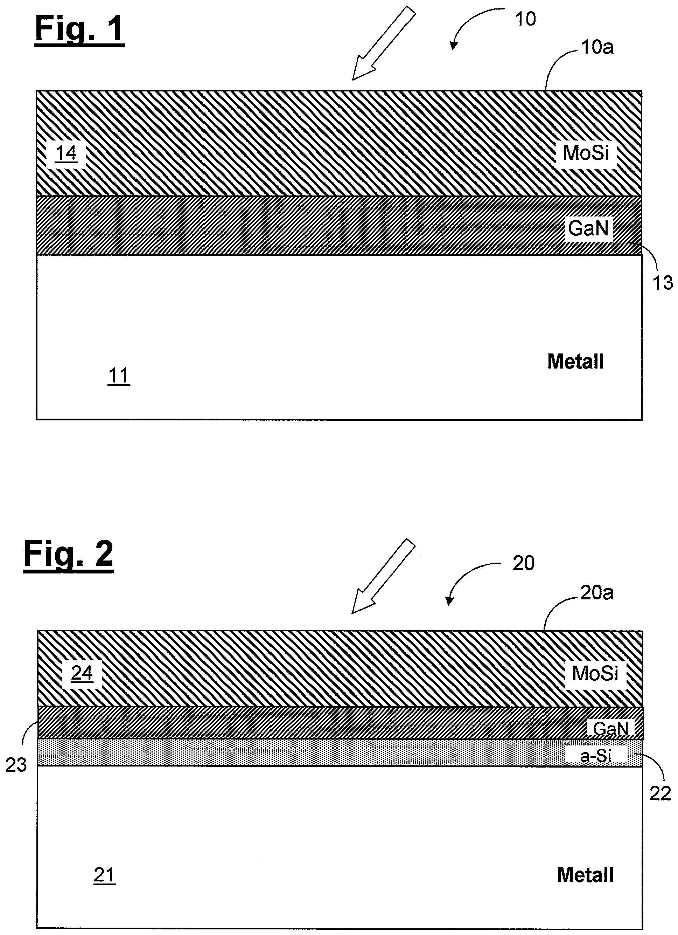

Fig. 1 zeigt eine schematische Darstellung zur Erläuterung des Aufbaus eines erfindungsgemäßen Spiegels in einer ersten Ausführungsform der Erfindung. Bei dem Spiegel 10 kann es sich insbesondere um einen EUV-Spiegel eines optischen Systems, insbesondere des Projektionsobjektivs oder der Beleuchtungseinrichtung einer mikrolithographischen Projektionsbelichtungsanlage, handeln.

Der Spiegel 10 umfasst insbesondere ein Spiegelsubstrat 11, welches in der ersten Ausführungsform aus einem metallischen Spiegelsubstratmaterial, beispielsweise Kupfer (Cu) oder Aluminium (Al), hergestellt ist.

Des Weiteren weist der Spiegel 10 in grundsätzlich für sich bekannter Weise ein Reflexionsschichtsystem 14 auf, welches in der dargestellten Ausführungsform lediglich beispielhaft einen Molybdän-Silizium (Mo-Si)-Schichtstapel (sowie ggf. Diffusionssperrschichten etc.) umfasst. Ohne dass die Erfindung auf konkrete Ausgestaltungen dieses Schichtstapels beschränkt wäre, kann ein lediglich beispielhafter geeigneter Aufbau etwa 50 Lagen bzw. Schichtpaketen eines Schichtsystems aus Molybdän (Mo)-Schichten mit einer Schichtdicke von jeweils 2.8nm und Silizium (Si)-Schichten mit einer Schichtdicke von jeweils 4.2nm umfassen. Gemäß Fig. 1 ist unmittelbar auf dem Spiegelsubstrat 11 eine Schicht 13 aus amorphem Galliumnitrid (GaN) angeordnet, welche (ohne dass die Erfindung hierauf beschränkt wäre) eine typische Dicke im Bereich von 0.1µm bis 100µm aufweisen kann und wie nachfolgend erläutert eine Doppelfunktion besitzt: Die Schicht 13 aus Galliumnitrid (GaN) dient zum einen als Polierschicht, um einer unzureichenden Polierbarkeit des darunter befindlichen metallischen Spiegelsubstrats 11 Rechnung zu tragen. Im Aufbau von Fig. 1 wird somit auf eine weitere Polierschicht etwa aus amorphem Silizium (= a-Si) verzichtet. Des Weiteren dient die Schicht 13 auch als Schutzschicht bzw. Absorberschicht, um einen Schutz des darunter befindlichen Spiegelsubstrats 11 zu gewährleisten.

Neben der vorstehend beschriebenen Doppelfunktion der Schicht 13 aus Gallium-nitrid (GaN) und der daraus resultierenden Vereinfachung des Schichtaufbaus hat diese den weiteren Vorteil, dass für Galliumnitrid (GaN) der Unterschied im Temperaturausdehnungskoeffizienten zum Reflexionsschichtstapel 14 einerseits und zum Spiegelsubstratmaterial andererseits noch geringer als für amorphes Silizium (a-Si) ist.

Hierzu sind in Tabelle 1 die thermischen Ausdehnungskoeffizienten für kristallines Galliumnitrid (GaN) im Vergleich zu den jeweiligen thermischen Ausdehnungskoeffizienten für typische Materialien des Reflexionsschichtstapels einerseits und des Spiegelsubstratmaterials andererseits aufgeführt.

**Tabelle 1:**

| | **Material** | **Thermischer Ausdehnungs-koeffizient** |
|---|---|---|
| **Spiegelsubstrat** | Kupfer (Cu) | 16.5·10⁻⁶ K⁻¹ |
| | Aluminium (Al) | 26.1·10⁻⁶ K⁻¹ |
| **Beschichtung** | Mo/Si- Reflexionsschichtstapel | 8·10⁻⁶ K⁻¹ |
| **Polierschicht** | a-Si | (2.6...3.5)·10⁻⁶ K⁻¹ |
| | GaN (kristallin) | 4.1·10⁻⁶ K⁻¹ |

Fig. 2 zeigt in schematischer Darstellung den Aufbau eines Spiegels in einer weiteren Ausführungsform, wobei zu Fig. 1 analoge bzw. im Wesentlichen funktionsgleiche Komponenten mit um "10" höheren Bezugsziffern bezeichnet sind.

Der Aufbau gemäß Fig. 2 unterscheidet sich von demjenigen aus Fig. 1 dadurch, dass auf dem Spiegelsubstrat 21 zunächst in für sich bekannter Weise eine Polierschicht 22 aus amorphem Silizium (a-Si) angeordnet ist, um einer unzureichenden Polierbarkeit des darunter befindlichen metallischen Spiegelsubstrats 21 Rechnung zu tragen. Die erfindungsgemäße Schicht 23 aus Galliumnitrid (GaN) befindet sich auf dieser Polierschicht 22 und dient dazu, als Absorberschicht einen Schutz sowohl der Polierschicht 22 als auch des darunter befindlichen Spiegelsubstratmaterials vor strahlungsinduzierten Effekten und strukturellen Änderungen infolge des EUV-Lichtes zu gewährleisten.

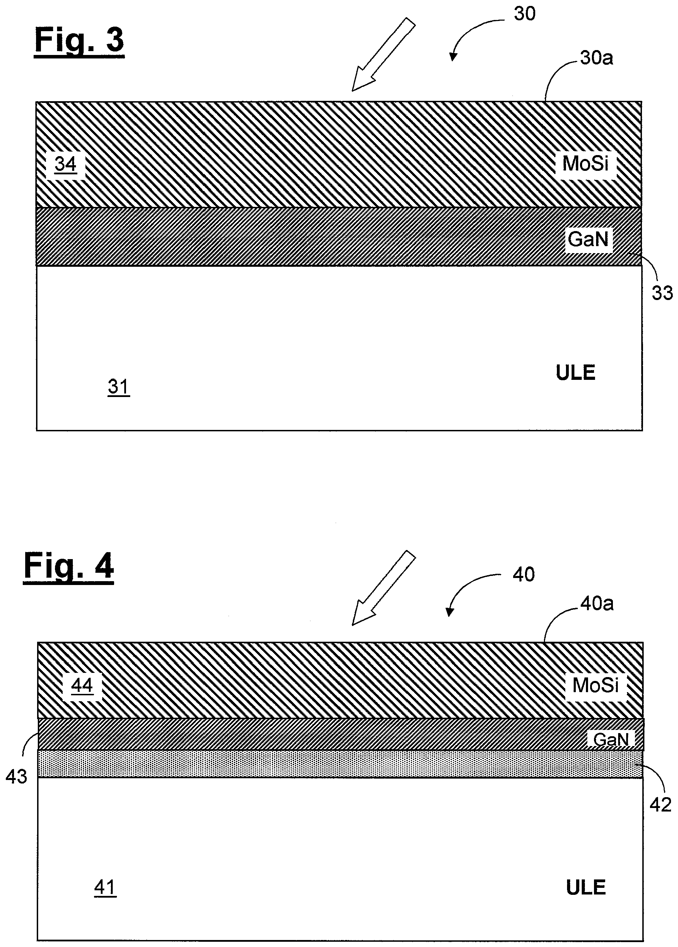

In weiteren Ausführungsformen kann es sich bei dem Spiegelsubstratmaterial auch um ein amorphes Material handeln, wie lediglich schematisch in Fig. 3 und Fig. 4 dargestellt ist. Geeignete Spiegelsubstratmaterialien sind z.B. Titandioxid (TiO₂)-dotiertes Quarzglas, wobei lediglich beispielhaft (und ohne dass die Erfindung hierauf beschränkt wäre) die unter den Markenbezeichnungen ULE oder Zerodur vertriebenen Materialien verwendbar sind.

Dabei sind in Fig. 3 zu Fig. 1 analoge bzw. im Wesentlichen funktionsgleiche Komponenten mit um "20" höheren Bezugsziffern bezeichnet. In Fig. 4 sind entsprechend zu Fig. 2 analoge bzw. im Wesentlichen funktionsgleiche Komponenten mit um "20" höheren Bezugsziffern bezeichnet, wobei hier auf dem Spiegelsubstrat 41 zunächst eine Haftvermittlerschicht 42 (z.B. aus Titannitrid, TiN) angeordnet ist, auf welcher sich dann die Schicht 43 aus Galliumnitrid (GaN) befindet.

Zur Herstellung eines erfindungsgemäßen Spiegels wird die Schicht 13, 23, 33 bzw. 43 aus z.B. Galliumnitrid vorzugsweise bei Raumtemperatur durch Stickstoffionen-gestütztes Aufdampfen aufgebracht. Dabei kann während der Beschichtung im Wege einer geeigneten "Verstellung" des Verhältnisses von Stickstoff (N) zu Gallium (Ga) ein Überangebot von Stickstoff in Verbindung mit einer vergleichsweise hohen Stickstoffionenenergie von z.B. mehreren 100 Elektronenvolt (eV) die Bildung von amorphem Material unter Vermeidung von Kristallitbildung gewährleistet werden.

Hinsichtlich geeigneter Verfahrensparameter für die Erzeugung einer amorphen Galliumnitridschicht wird beispielhaft auf Uday Lanke et al.: "Effect of ion-energy on the properties of amorphous GaN films produced by ion-assisted deposition", Modern Physics Letters B, Vol. 15, Nos. 28 & 29 (2001), S. 1355-1360; A. Bittar et al.: "Ion-assisted deposition of amorphous GaN: Raman and optical properties", Applied Physics Letters, Vol. 78, Number 5, 29. Januar 2001, S. 619-621; H. J. Trodahl et al.: "Raman spectroscopy of nanocrystalline and amorphous GaN", Journal of Applied Physics 97, (2005), S. 084309-1 bis 084309-5; V.J. Kennedy et al.: "Ion beam analysis of ion-assisted deposited amorphous GaN", Nuclear Instruments and Methods in Physics Research B 190 (2002), S. 620-624; B. J. Ruck et al.: "Quantitative study of molecular N2 trapped in disordered GaN:O films", Physical Review B 70 (2004), S. 235202-1 bis 235202-5 verwiesen.

In weiteren Ausführungsformen kann die Schicht 13, 23, 33 bzw. 43 aus z.B. Galliumnitrid auch mit einem anderen geeigneten Verfahren wie z.B. Sputtern, nachträgliche Ionenimplantation etc. aufgebracht werden.

Nach dem Aufbringen der Schicht 13, 23, 33 bzw. 43 aus z.B. Galliumnitrid gemäß den Ausführungsformen von Fig. 1-4 kann diese poliert werden, um den Reflexionsschichtstapel in der erforderlichen Exaktheit aufzubringen. Bei einem solchen Polierschritt kann in die Schicht 13, 23, 33 bzw. 43 aus z.B. Galliumnitrid auch gezielt ein Oberflächenprofil (z.B. ein bestimmter Krümmungsradius oder eine Freiformfläche) eingearbeitet werden, um etwa eine in dem Schichtsystem des Spiegels vorhandene mechanische Verspannung und eine damit einhergehende unerwünschte Deformation des Spiegels wenigstens teilweise zu kompensieren. Sofern die Rauigkeit der Schicht 13, 23, 33 bzw. 43 nach dem Aufbringen bereits hinreichend gering (z.B. kleiner als 0.1nm rms) und kein gezieltes Oberflächenprofil erwünscht ist, kann ggf. auch auf einen solchen Polierschritt verzichtet werden.

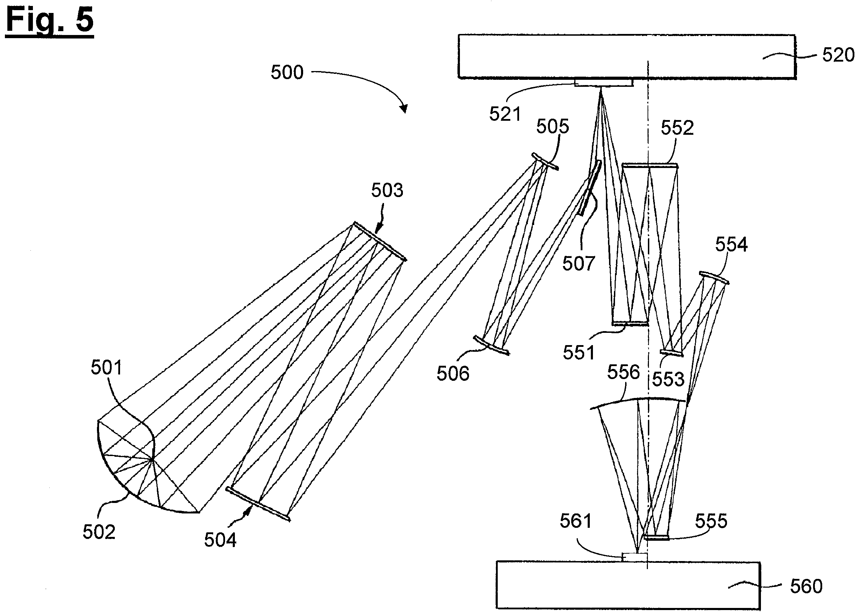

Fig. 5 zeigt eine schematische Darstellung einer beispielhaften für den Betrieb im EUV ausgelegten Projektionsbelichtungsanlage, in welcher die vorliegende Erfindung realisierbar ist.

Gemäß Fig. 5 weist eine Beleuchtungseinrichtung in einer für EUV ausgelegten Projektionsbelichtungsanlage 500 einen Feldfacettenspiegel 503 und einen Pupillenfacettenspiegel 504 auf. Auf den Feldfacettenspiegel 503 wird das Licht einer Lichtquelleneinheit, welche eine Plasmalichtquelle 501 und einen Kollektorspiegel 502 umfasst, gelenkt. Im Lichtweg nach dem Pupillenfacettenspiegel 504 sind ein erster Teleskopspiegel 505 und ein zweiter Teleskopspiegel 506 angeordnet. Im Lichtweg nachfolgend ist ein Umlenkspiegel 507 angeordnet, der die auf ihn treffende Strahlung auf ein Objektfeld in der Objektebene eines sechs Spiegel 551-556 umfassenden Projektionsobjektivs lenkt. Am Ort des Objektfeldes ist eine reflektive strukturtragende Maske 521 auf einem Maskentisch 520 angeordnet, die mit Hilfe des Projektionsobjektivs in eine Bildebene abgebildet wird, in welcher sich ein mit einer lichtempfindlichen Schicht (Photoresist) beschichtetes Substrat 561 auf einem Wafertisch 560 befindet.

Der Feldfacettenspiegel 503, der Pupillenfacettenspiegel 504 oder auch der Umlenkspiegel 507 können beispielsweise ein Spiegelsubstrat aus einem metallischen Spiegelsubstratmaterial wie z.B. Kupfer (Cu) oder Aluminium (Al) aufweisen und beispielsweise entsprechend der Ausführungsform von Fig. 1 mit einer Schicht 13 aus Galliumnitrid (GaN) ausgestaltet sein, welche insbesondere als Polierschicht, um eine präzisere Bearbeitung im Vergleich zu dem metallischen Spiegelsubstratmaterial zu ermöglichen, sowie auch als Schutzschicht dient.

Die Spiegel 551-556 des Projektionsobjektivs können beispielsweise ein Spiegelsubstrat aus einem amorphen Spiegelsubstratmaterial wie Titandioxid (TiO₂)-dotiertem Quarzglas (z.B. ULE oder Zerodur) aufweisen und beispielsweise wie unter Bezugnahme auf Fig. 3 beschrieben mit einer Schicht 33 aus Galliumnitrid (GaN) ausgestaltet sein, welche sowohl als Polierschicht als auch als Schutzschicht bzw. Absorberschicht zum Schutz des darunter befindlichen Spiegelsubstratmaterials dient.

Die Erfindung ist jedoch nicht auf die Anwendung auf die vorstehend genannten Spiegel beschränkt, so dass grundsätzlich auch andere Spiegel in der erfindungsgemäßen Weise ausgestaltet werden können.

Wenn die Erfindung auch anhand spezieller Ausführungsformen beschrieben wurde, erschließen sich für den Fachmann zahlreiche Variationen und alternative Ausführungsformen, z.B. durch Kombination und/oder Austausch von Merkmalen einzelner Ausführungsformen. Dementsprechend versteht es sich für den Fachmann, dass derartige Variationen und alternative Ausführungsformen von der vorliegenden Erfindung mit umfasst sind, und die Reichweite der Erfindung nur im Sinne der beigefügten Patentansprüche beschränkt ist. Die vorliegende Anmeldung umfasst Aspekte, die in den nachfolgenden Sätzen definiert sind, welche einen Teil der Beschreibung bilden, aber keine Patenansprüche darstellen, im Einklang mit der Entscheidung J15/88 der juristischen Beschwerdekammer des Europäischen Patentamts.
1. Spiegel, wobei der Spiegel eine optische Wirkfläche aufweist, mit einem Spiegelsubstrat und einem Reflexionsschichtstapel zur Reflexion von auf die optische Wirkfläche auftreffender elektromagnetischer Strahlung, wobei zwischen dem Spiegelsubstrat und dem Reflexionsschichtstapel eine Schicht aus einem Gruppe-III-Nitrid angeordnet ist, wobei das Gruppe-III-Nitrid aus der Gruppe ausgewählt ist, die Galliumnitrid (GaN), Aluminiumnitrid (AlN) und Aluminium-Gallium-Nitrid (AlGaN) enthält.
2. Spiegel nach Satz 1, dadurch gekennzeichnet, dass das Gruppe-III-Nitrid amorph ist.
3. Spiegel nach Satz 1 oder 2, dadurch gekennzeichnet, dass die Schicht eine Dicke im Bereich von 0.1 µm bis 100 µm, insbesondere im Bereich von 0.5 µm bis 50 µm, aufweist.
4. Spiegel nach einem der Sätze 1 bis 3, dadurch gekennzeichnet, dass die Schicht unmittelbar auf dem Spiegelsubstrat oder auf einer auf dem Spiegelsubstrat befindlichen Haftvermittlerschicht angeordnet ist.
5. Spiegel nach einem der Sätze 1 bis 3, dadurch gekennzeichnet, dass die Schicht auf einer Polierschicht angeordnet ist.
6. Spiegel nach einem der Sätze 1 bis 5, dadurch gekennzeichnet, dass das Spiegelsubstrat aus einem metallischen Material hergestellt ist.
7. Spiegel nach einem der Sätze 1 bis 5, dadurch gekennzeichnet, dass das Spiegelsubstrat aus einem amorphen Material, insbesondere Titandioxid (TiO₂)-dotiertem Quarzglas, hergestellt ist.
8. Spiegel nach einem der vorhergehenden Sätze, dadurch gekennzeichnet, dass der Spiegel für eine Arbeitswellenlänge von weniger als 30 nm, insbesondere weniger als 15 nm, ausgelegt ist.
9. Spiegel nach einem der vorhergehenden Sätze, dadurch gekennzeichnet, dass dieser ein Spiegel einer mikrolithographischen Projektionsbelichtungsanlage ist.
10. Optisches System einer mikrolithographischen Projektionsbelichtungsanlage, insbesondere Beleuchtungseinrichtung oder Projektionsobjektiv, mit wenigstens einem Spiegel nach einem der vorhergehenden Sätze.
11. Verfahren zum Herstellen eines Spiegels für eine mikrolithographische Projektionsbelichtungsanlage, wobei auf einem Spiegelsubstrat ein Schichtsystem aufgebracht wird, welches einen Reflexionsschichtstapel zur Reflexion von auf die optische Wirkfläche auftreffender elektromagnetischer Strahlung aufweist, wobei vor dem Aufbringen des Reflexionsschichtstapels eine Schicht aus einem Gruppe-III-Nitrid aufgebracht wird, wobei das Gruppe-III-Nitrid aus der Gruppe ausgewählt ist, die Galliumnitrid (GaN), Aluminiumnitrid (AlN) und Aluminium-Gallium-Nitrid (AlGaN) enthält.
12. Verfahren nach Satz 11, dadurch gekennzeichnet, dass die Schicht vor Aufbringen des Reflexionsschichtstapels poliert wird.
13. Verfahren nach Satz 11 oder 12, dadurch gekennzeichnet, dass in die Schicht ein Oberflächenprofil eingearbeitet wird, welches eine in dem Schichtsystem des Spiegels vorhandene, durch mechanische Verspannung induzierte Deformation wenigstens teilweise kompensiert.

## Patentansprüche

1. Spiegel einer mikrolithographischen Projektionsbelichtungsanlage, wobei der Spiegel eine optische Wirkfläche aufweist, mit
• einem Spiegelsubstrat (11, 21, 31, 41); und
• einem Reflexionsschichtstapel (14, 24, 34, 44) zur Reflexion von auf die optische Wirkfläche (10a, 20a, 30a, 40a) auftreffender elektromagnetischer Strahlung;
• wobei zwischen dem Spiegelsubstrat (11, 21, 31, 41) und dem Reflexionsschichtstapel (14, 24, 34, 44) eine Schicht (13, 23, 33, 43) aus einem Gruppe-III-Nitrid angeordnet ist, wobei das Gruppe-III-Nitrid aus der Gruppe ausgewählt ist, die Galliumnitrid (GaN), Aluminiumnitrid (AlN) und Aluminium-Gallium-Nitrid (AlGaN) enthält;
**dadurch gekennzeichnet, dass**
• die Schicht (13, 23, 33, 43) eine Dicke im Bereich von 0.1 µm bis 100 µm aufweist.

2. Spiegel nach Anspruch 1, **dadurch gekennzeichnet, dass** das Gruppe-III-Nitrid amorph ist.

3. Spiegel nach Anspruch 1 oder 2, **dadurch gekennzeichnet, dass** die Schicht (13, 23, 33, 43) eine Dicke im Bereich von 0.5 µm bis 50 µm aufweist.

4. Spiegel nach einem der Ansprüche 1 bis 3, **dadurch gekennzeichnet, dass** die Schicht (13, 33, 43) unmittelbar auf dem Spiegelsubstrat (11, 31) oder auf einer auf dem Spiegelsubstrat (41) befindlichen Haftvermittlerschicht (42) angeordnet ist.

5. Spiegel nach einem der Ansprüche 1 bis 3, **dadurch gekennzeichnet, dass** die Schicht (23) auf einer Polierschicht (22) angeordnet ist.

6. Spiegel nach einem der Ansprüche 1 bis 5, **dadurch gekennzeichnet, dass** das Spiegelsubstrat (11, 21) aus einem metallischen Material hergestellt ist.

7. Spiegel nach einem der Ansprüche 1 bis 5, **dadurch gekennzeichnet, dass** das Spiegelsubstrat (31, 41) aus einem amorphen Material, insbesondere Titandioxid (TiO₂)-dotiertem Quarzglas, hergestellt ist.

8. Spiegel nach einem der vorhergehenden Ansprüche, **dadurch gekennzeichnet, dass** der Spiegel (10, 20, 30, 40) für eine Arbeitswellenlänge von weniger als 30 nm, insbesondere weniger als 15 nm, ausgelegt ist.

9. Optisches System einer mikrolithographischen Projektionsbelichtungsanlage (500), insbesondere Beleuchtungseinrichtung oder Projektionsobjektiv, mit wenigstens einem Spiegel nach einem der vorhergehenden Ansprüche.

10. Verfahren zum Herstellen eines Spiegels für eine mikrolithographische Projektionsbelichtungsanlage, wobei auf einem Spiegelsubstrat (11, 21, 31, 41) ein Schichtsystem aufgebracht wird, welches einen Reflexionsschichtstapel (14, 24, 34, 44) zur Reflexion von auf die optische Wirkfläche (10a, 20a, 30a, 40a) auftreffender elektromagnetischer Strahlung aufweist, wobei vor dem Aufbringen des Reflexionsschichtstapels (14, 24, 34, 44) eine Schicht (13, 23, 33, 43) aus einem Gruppe-III-Nitrid aufgebracht wird, wobei das Gruppe-III-Nitrid aus der Gruppe ausgewählt ist, die Galliumnitrid (GaN), Aluminiumnitrid (AlN) und Aluminium-Gallium-Nitrid (AlGaN) enthält, und wobei die Schicht (13, 23, 33, 43) eine Dicke im Bereich von 0.1 µm bis 100 µm aufweist.

11. Verfahren nach Anspruch 10, **dadurch gekennzeichnet, dass** die Schicht (13, 23, 33, 43) vor Aufbringen des Reflexionsschichtstapels (14, 24, 34, 44) poliert wird.

12. Verfahren nach Anspruch 10 oder 11, **dadurch gekennzeichnet, dass** in die Schicht (13, 23, 33, 43) ein Oberflächenprofil eingearbeitet wird, welches eine in dem Schichtsystem des Spiegels (10, 20, 30, 40) vorhandene, durch mechanische Verspannung induzierte Deformation wenigstens teilweise kompensiert.

## Claims

1. Mirror of a microlithographic projection exposure apparatus, wherein the mirror has an optical effective surface, comprising
• a mirror substrate (11, 21, 31, 41); and
• a reflection layer stack (14, 24, 34, 44) for reflecting electromagnetic radiation impinging on the optical effective surface (10a, 20a, 30a, 40a);
• wherein a layer (13, 23, 33, 43) composed of a group III nitride is arranged between the mirror substrate (11, 21, 31, 41) and the reflection layer stack (14, 24, 34, 44), wherein the group III nitride is selected from the group containing gallium nitride (GaN), aluminum nitride (AlN) and aluminum gallium nitride (AlGaN);
**characterized in that** the layer (13, 23, 33, 43) has a thickness in the range of 0.1 µm to 100 µm.

2. Mirror according to Claim 1, **characterized in that** the group III nitride is amorphous.

3. Mirror according to Claim 1 or 2, **characterized in that** the layer (13, 23, 33, 43) has a thickness in the range of 0.5 µm to 50 µm.

4. Mirror according to any of Claims 1 to 3, **characterized in that** the layer (13, 33, 43) is arranged directly on the mirror substrate (11, 31) or on an adhesion promoter layer (42) situated on the mirror substrate (41).

5. Mirror according to any of Claims 1 to 3, **characterized in that** the layer (23) is arranged on a polishing layer (22).

6. Mirror according to any of Claims 1 to 5, **characterized in that** the mirror substrate (11, 21) is produced from a metallic material.

7. Mirror according to any of Claims 1 to 5, **characterized in that** the mirror substrate (31, 41) is produced from an amorphous material, in particular titanium dioxide (TiO₂)-doped quartz glass.

8. Mirror according to any of the preceding claims, **characterized in that** the mirror (10, 20, 30, 40) is designed for an operating wavelength of less than 30 nm, in particular less than 15 nm.

9. Optical system of a microlithographic projection exposure apparatus (500), in particular an illumination device or a projection lens, comprising at least one mirror according to any of the preceding claims.

10. Method for producing a mirror for a microlithographic projection exposure apparatus, wherein a layer system is applied on a mirror substrate (11, 21, 31, 41), said layer system having a reflection layer stack (14, 24, 34, 44) for reflecting electromagnetic radiation impinging on the optical effective surface (10a, 20a, 30a, 40a), wherein a layer (13, 23, 33, 43) composed of a group III nitride is applied before the reflection layer stack (14, 24, 34, 44) is applied, wherein the group III nitride is selected from the group containing gallium nitride (GaN), aluminum nitride (AlN) and aluminum gallium nitride (AlGaN), and wherein the layer (13, 23, 33, 43) has a thickness in the range of 0.1 µm to 100 µm.

11. Method according to Claim 10, **characterized in that** the layer (13, 23, 33, 43) is polished before the reflection layer stack (14, 24, 34, 44) is applied.

12. Method according to Claim 10 or 11, **characterized in that** a surface profile is worked into the layer (13, 23, 33, 43), said surface profile at least partly compensating for a deformation which is present in the layer system of the mirror (10, 20, 30, 40) and which is induced by mechanical strain.

## Revendications

1. Miroir d'un appareil d'exposition par projection microlithographique, dans lequel le miroir présente une surface optique effective, comportant
• un substrat de miroir (11, 21, 31, 41) ; et
• un empilement de couches réfléchissantes (14, 24, 34, 44) pour réfléchir un rayonnement électromagnétique incident sur la surface optique effective (10a, 20a, 30a, 40a) ;
• dans lequel une couche (13, 23, 33, 43) constituée d'un nitrure du groupe III est disposée entre le substrat de miroir (11, 21, 31, 41) et l'empilement de couches réfléchissantes (14, 24, 34, 44), dans lequel le nitrure du groupe III est choisi dans le groupe constitué du nitrure de gallium (GaN), du nitrure d'aluminium (AlN) et du nitrure de gallium-aluminium (AlGaN) ;
**caractérisé en ce que**
• la couche (13, 23, 33, 43) présente une épaisseur se situant dans la plage de 0,1 µm à 100 µm.

2. Miroir selon la revendication 1, **caractérisé en ce que** le nitrure du groupe III est amorphe.

3. Miroir selon la revendication 1 ou 2, **caractérisé en ce que** la couche (13, 23, 33, 43) présente une épaisseur se situant dans la plage de 0,5 µm à 50 µm.

4. Miroir selon l'une des revendications 1 à 3, **caractérisé en ce que** la couche (13, 33, 43) est disposée directement sur le substrat de miroir (11, 31) ou sur une couche favorisant l'adhérence (42) située sur le substrat de miroir (41).

5. Miroir selon l'une des revendications 1 à 3, **caractérisé en ce que** la couche (23) est disposée sur une couche de polissage (22).

6. Miroir selon les revendications 1 à 5, **caractérisé en ce que** le substrat de miroir (11, 21) est réalisé à partir d'un matériau métallique.

7. Miroir selon l'une des revendications 1 à 5, **caractérisé en ce que** le substrat de miroir (31, 41) est réalisé à partir d'un matériau amorphe, en particulier un verre de quartz dopé au dioxyde de titane (TiO₂).

8. Miroir selon l'une des revendications précédentes, **caractérisé en ce que** le miroir (10, 20, 30, 40) est conçu pour une longueur d'onde de fonctionnement inférieure à 30 nm, en particulier inférieure à 15 nm.

9. Système optique d'un appareil d'exposition par projection microlithographique (500), notamment dispositif d'éclairage ou objectif de projection, comportant au moins un miroir selon l'une des revendications précédentes.

10. Procédé de réalisation d'un miroir destiné à un appareil d'exposition par projection microlithographique, dans lequel un système de couches est déposé sur un substrat de miroir (11, 21, 31, 41), lequel système de couches comporte un empilement de couches réfléchissantes (14, 24, 34, 44) destinées à réfléchir un rayonnement électromagnétique incident sur la surface optique effective (10a, 20a, 30a, 40a), dans lequel une couche (13, 23, 33, 43) constituée d'un nitrure du groupe III est déposée avant le dépôt de l'empilement de couches réfléchissantes (14, 24, 34, 44),
dans lequel le nitrure du groupe III est choisi dans le groupe constitué du nitrure de gallium (GaN), du nitrure d'aluminium (AlN) et du nitrure d'aluminium-gallium (AlGaN), et dans lequel la couche (13, 23, 33, 43) présente une épaisseur se situant dans la plage de 0,1 µm à 100 µm.

11. Procédé selon la revendication 10, **caractérisé en ce que** la couche (13, 23, 33, 43) est polie avant le dépôt de l'empilement de couches réfléchissantes (14, 24, 34, 44).

12. Procédé selon la revendication 10 ou 11, **caractérisé en ce qu'**un profil de surface est ménagé dans la couche (13, 23, 33, 43), celui-ci compensant au moins en partie une déformation qui est présente dans le système de couches du miroir (10, 20, 30, 40) et est induite par une contrainte mécanique.
